# EUROPEAN PATENT SPECIFICATION

(11) **EP 1 537 732 B1**
(45) Date of publication and mention of the grant of the patent: **22.04.2009**
(21) Application number: 03793880.0
(22) Date of filing: 04.09.2003
(51) Int. Cl.: H04N 5/50, H03J 1/00

(54) **IMPROVEMENTS TO TELEVISION AND RADIO PROGRAMME CONTROL**
VERBESSERUNGEN AN DER REGELUNG VON FERNSEH- UND RUNDFUNKPROGRAMMEN
AMELIORATIONS APPORTEES A LA COMMANDE DE PROGRAMMES DE TELEVISION ET DE RADIO

(30) Priority: 07.09.2002 GB 0220843
(43) Date of publication of application: 08.06.2005
(73) Proprietor: Panasonic Corporation, Kadoma-shi Osaka 571-8501 (JP)
(72) Inventor: ROBERTSON, George, Michael, Edinburgh EH6 5NP (GB)
(74) Representative: Kinsler, Maureen Catherine
(86) International application number: PCT/GB2003/003826
(87) International publication number: WO 2004/023800

(56) References cited:
- US-B1- 6 411 343
- PATENT ABSTRACTS OF JAPAN vol. 2002, no. 03, 3 April 2002 (2002-04-03) & JP 2001 309253 A (MATSUSHITA ELECTRIC IND CO LTD), 2 November 2001 (2001-11-02)
- PATENT ABSTRACTS OF JAPAN vol. 2002, no. 03, 3 April 2002 (2002-04-03) & JP 2001 326862 A (SHARP CORP), 22 November 2001 (2001-11-22)

## Description

The present invention relates to an improved system and method of channel scanning in television and/or radio systems.

Digital television can deliver hundreds of channels. Because of this, users need a simple and efficient method of navigating these channels. Electronic programme guides (EPGs) address this problem to an extent. However, despite the relatively sophisticated functionality provided by EPGs, it seems that people continue to 'hop' or 'surf' or switch through the range of available channels using their remote controls. This is commonly referred to as "zapping". That is, viewers simply use the 'programme up' and 'programme down' controls. Hence, a viewer may look through many, many channels before deciding to stop and watch something. If that item, or program, on that channel fails to interest the viewer, they restart their search. A difficulty with this is that they have to re-scan many channels again.

Channel zapping on a digital television also suffers from the problem that it can take a perceptible time to decode and, possibly, decrypt incoming signals, such as MPEG, DVB, ATSC or ARIB streams. Some channel changes inevitably involve the changing of receiver frequency or polarisation. This means that the receiver has to begin demodulating a new radio frequency signal. These problems exist for all types of modulation, including COFDM, 8-VSB, QAM, etc. This means that the user experiences a delay changing channels on a digital TV system, whereas an analogue system changes channel almost instantly. This can be particularly annoying for the user if they have to scan through numerous channels that they have already viewed.

The document JP-A-2001 309 253 discloses a method of channel changes in television. The method includes monitoring channel change commands during which channels are discarded by setting a lock ID in a table. During a zapping command, discarded channels are identified and skipped during the following zapping sessions. The lock ID is set manually by the user for each channel to be discarded by activating a lock function.

The document DE-A-199 33422 describes a method of building a preferred channel list during a video session. In order to decide which channel is selected for the list of preferred channels, the method measures the viewing time during which the receiver has been tuned to a particular channel. If the viewing time is longer than a given threshold the channel is included in the list of preferred channels.

An object of the invention is to provide improved channel scan functionality for television and digital radio.

Various aspects of the invention are defined in the independent claims. Some preferred features are defined in the dependent claims.

Various aspects of the invention will now be described by way of example only and with reference to the accompanying drawings, of which:
Figure 1 is a block diagram of system that has an enhanced channel zapping capability;
Figure 2 is a flow diagram of the steps for switching into the enhanced channel zapping mode;
Figure 3 is a flow diagram of a top level process of the enhanced channel zapping capability;
Figure 4 is a flow diagram of a part of the process of Figure 3, and
Figure 5 is a flow diagram of a portion of the process of Figure 4.

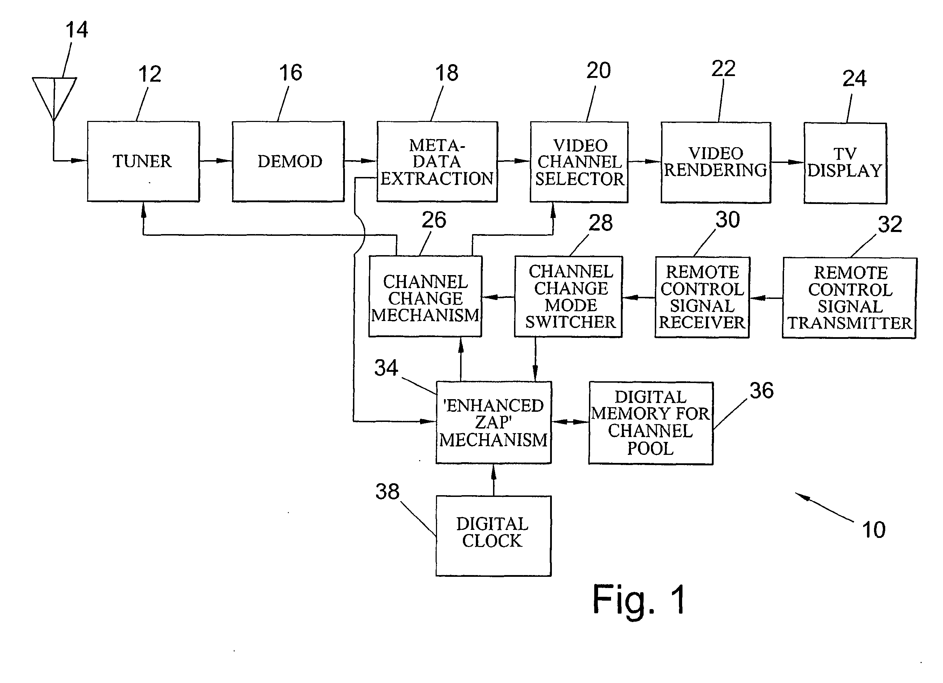

Figure 1 shows a digital television 10 that includes enhanced channel-zapping functionality. The system of Figure 1 has a tuner 12, which is responsible for picking out the correct broadcast signal from the attached antenna 14 or cable distribution system. Connected to the tuner 12 is a demodulator 16 for producing a digital bit stream from the received signal. Connected to an output of the demodulator 16 is a meta-data extractor 18 for extracting from the demodulated bit stream a digital description of the TV channels included in that bit stream, as well as the TV programmes and/or items that are currently being or are scheduled to be broadcast. This 'digital description' (or meta-data) can include any one of a number of programme identifiers. These will be described in more detail later. After the meta-data extraction stage, the signal is passed to a video channel selector 20, which selects from the bit stream the desired digital TV channel. Connected to the video selector 20 is a video rendering module 22 for converting the selected digital TV channel signal to a viewable format. The output of the video-rendering module 22 is input to a display 24, which is typically a television screen.

In order to control channel changes, a channel change mechanism 26 is provided. This is connected to and controls the tuner 12 and the video channel selector 20 to ensure that the selected TV channel is received, decoded and displayed. The channel change mechanism 26 receives channel change commands from a channel change mode switcher 28. The channel change mode switcher 28 receives control signals from a remote control signal receiver 30, which in turn receives channel change signals from the user via a remote control unit 32, as shown. Alternatively, signals may also be received from "up" and "down" channel change controls on the front panel of the television.

Connected to the channel change mode switcher 28 is an enhanced zap mechanism 34. This includes software for implementing enhanced zapping functionality. In addition to forwarding routine channel changes to the channel change mechanism 26, the channel change mode switcher 28 is operable to switch an enhanced zap mode on and off. When the enhanced zap mode is on, channel change commands are forwarded to the enhanced zap mechanism 34, instead of directly to the channel change mechanism 26. Associated with the zap mechanism 34 are a memory 36 for storing the pool of channels that are available during the channel zapping session and a digital clock 38. To switch between the different mechanisms, the channel change mode switcher 28 is responsive to commands received from the user.

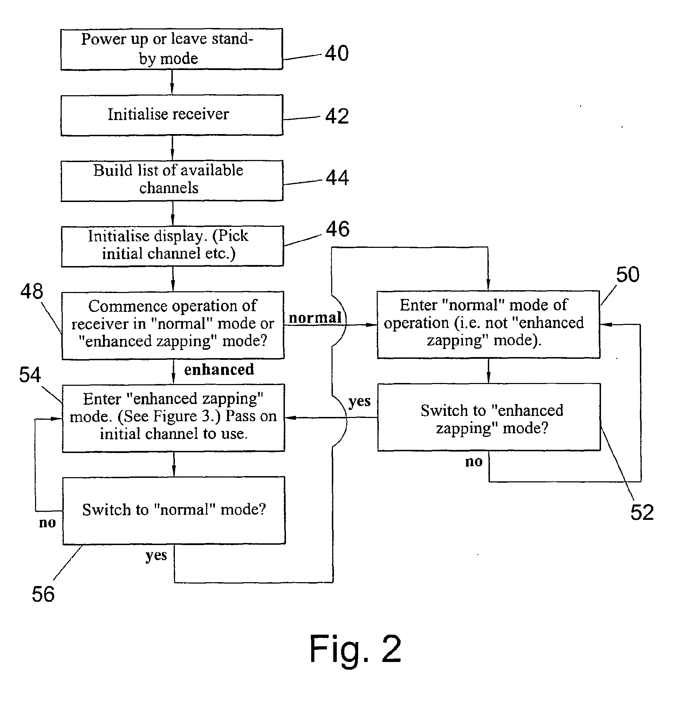

Figure 2 shows the steps taken when the television is switched on initially. As is standard, the receiver 12 is powered-up 40; initialised 42; a list of available channels is identified 44, and the display 24 is initialised, i.e. the initial channel is picked and displayed on screen 46. The receiver 12 is then ready to receive channel change commands from the user. This can be done in two modes, these being "normal" and "enhanced zap". Typically, the default is the normal mode, with the enhanced zap mode being activated in response to a user command.

To allow the generation of the "enter enhanced zap" command, the remote control is adapted to be able to send an enhanced zap control signal, which when received is recognised by the channel change mode switcher 28 and causes the enhanced zap mechanism 34 to be activated. Typically, the remote control 32 will have a dedicated enhanced zap button and the system is set up so that the enhanced zap button on the remote control is able to toggle between the enhanced zap mode and the normal mode. Optionally, this enhanced zap button may be operable to effect channel change commands for receipt by the enhanced zap mechanism, by for example being configured to have the effect of a 'channel up' button. Alternatively, another zap button may be provided to have the effect of a channel change button, typically a 'channel up' button.

When the television is switched on initially and the enhanced zap mode is off, the channel change mode switcher recognises 48 that the mode of operation is the normal mode. Operation is then commenced 50 in the normal mode. In this mode, signals from the remote control unit are relayed via the channel change mode switcher 28 to the channel change mechanism 26, which causes the channel to be changed, as is normal. However, when the enhanced zap mode is activated, the channel change mode switcher 28 recognises this as a switch mode command 52 and so switches to the enhanced zap mode 54. Once this is done, signals from the remote control unit are relayed by the channel change mode switcher 28 to the enhanced zap mechanism 34. The user can change 56 from enhanced zap mode at any stage by causing the appropriate mode command to be sent. This causes the mode switcher to switch to the normal mode.

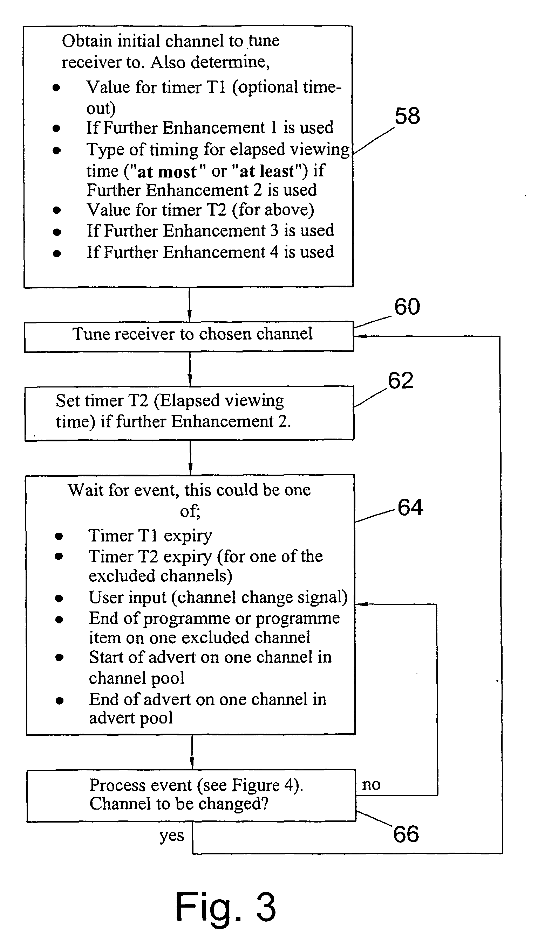

Details of the functionality provided by the enhanced zap mechanism will be described in more detail with reference to Figures 3 to 5. In essence, however, when the enhanced zapping mode is activated, channel change commands are not passed directly to the channel change mechanism 28, but instead are sent via the enhanced zap mechanism 34. The zap mechanism 34 is operable to receive and monitor channel change commands received from the user over a zapping session. Using pre-determined criteria, the enhanced zap mechanism 34 determines which channels are of no interest to the user. In the event that the user re-starts the channel scan within the same zapping session, the enhanced zap mechanism 34 only passes on the change channel commands for those channels that have not been discarded. In this way, the enhanced zap mechanism 34 prevents the tuner or receiver from returning to the discarded channels during the rest of the zapping session or until it is determined that a programme transmitted on the discarded channel has changed.

Various methods can be used to identify the programmes that are of no interest to a viewer in a single channel zapping session and determine when the channels showing these programmes can be re-introduced into the pool of channels available for channel hopping. In one case, the enhanced channel zapping mechanism 34 uses programme, or item, identifiers. Modern digital TV transmission systems broadcast, or have the ability to broadcast, extra information concerning the current broadcast. This can include some form of digital description of the current broadcast, or a digital identifier for the programme or item being broadcast. This identifier is synonymous with the programme or item currently being broadcast, i.e. the identifier unambiguously identifies the programme or item. The channel zapping mechanism 34 is operable to monitor the identifier associated with channels that have been scanned and discarded by the user. This is done using data provided by the meta-data extraction module 18. The enhanced zap mechanism then prevents the tuner 12 from being re-tuned to these channels until either a pre-set time has elapsed or the programme identifier has changed.

A non-exhaustive list of identifiers includes the content reference ID (CRID) from the TV-Anytime forum; the instance meta-data identifier (IMDI) from the TV-Anytime forum; any URI, URN or URL as defined in any of the IETF RFC documents; the DAVIC/DVB URL format; the DVB event ID; the SMPTE UPID and UMID and the ISO ISAN and V-ISAN.

In another method, it is possible to identify programmes that are of no interest to a viewer and determine when the channels showing these programmes can be re-introduced into the pool of channels using event information tables (EIT). For DVB digital television, it is mandatory to transmit event information tables (EIT) to tell the DVB television receiver about the current and next item, event or programme to be shown on a DVB service. When the EIT is used in this way it is known as the `present/following' table. Its primary use is to help with channel hopping. It allows an on-screen display to inform the user that, "Programme A is on now," and, "Programme B is on next." In this way, the user can see, at a glance, what the service is showing at present and what it will be showing next. EIT information is available for all services in the DVB multiplex (that is, the transmitted MPEG transport stream). Also, present/following information is 'cross carried' on other multiplexes of the same operator. Thus, on any particular platform, it is not necessary to re-tune to access the present/following information of a service carried within another multiplex.

In one method of enhanced channel zapping a list of all the DVB services that can be viewed is used. When the enhanced 'zapping' mode is engaged, information associated with the elements of this list is used to determine whether a service is available for `zapping' or 'channel hopping.' When the mode is engaged and a channel is selected, a flag associated with that service is set. This flag represents that the channel has been zapped to. The present/following information for this service is noted. This service is now not available for channel hopping until either the present/following information for this service changes or an optional time limit has expired.

In the DVB method described above in-band signalling is used to determine whether the current programme has changed. In an alternative method, TV schedule meta-data can be used. That is, the data that is broadcast within the transport stream (TS) to allow the provision of an EPG. Examples of this data include DVB-SI, and the TV-Anytime Meta-data and Content Referencing specifications. In this case, the digital TV receiver maintains a database of the current TV schedule. The digital TV receiver maintains an internal accurate clock based on data broadcast in the TS. Thus, the digital TV receiver is able to determine, in a time-based fashion, whether a programme is currently showing on air. In this case, when the enhanced zapping mode is engaged, information associated with the elements of this list is used to determine whether a service is available for zapping or channel hopping. When the mode is engaged and a channel is selected, a flag associated with that service is set. This flag represents that the channel has been zapped to. This service is now not available for channel hopping until the digital TV receiver determines that a new programme is showing or an optional time limit has expired. As before, when channels are zapped to, and discarded, they are removed from the pool of channels that can be zapped to. These channels reappear in the pool of channels that can be zapped to as new programmes appear on them.

It is possible to extend the enhanced zapping functionality, from working at the programme level, to also work at the programme item or segment level. When channel hopping, the viewer may regain interest in a channel if a new item is shown. For example, one news report may be of no interest, but the next may of interest. This is possible using the TV-Anytime Meta-data specification, which allows the broadcaster to signal that an advertisement is currently showing. If the viewer zaps to a channel that is showing an advertisement and then moves to another channel before the main programme resumes, then the viewer has not had the opportunity to assess whether or not the programme is of interest. In this case, the channel should not be removed from the pool of channels that can be zapped to.

In this implementation of the invention, the digital TV receiver maintains a list of the digital programme identifiers for the programmes or programme items showing on each of the digital TV services available. This method of enhanced channel zapping uses a list of all the digital TV services that can be viewed. When the enhanced zapping mode is engaged, information associated to the elements of this list is used to determine whether a service is available for zapping or channel hopping. When the mode is engaged and a channel is selected, the digital programme identifier for the programme (or item) showing on this service is noted. This service is now not available for channel hopping until a new programme or item is showing (that is a new digital programme ID is broadcast) or an optional time limit has expired. Thus, as channels are zapped to, and discarded, they are removed from the pool of channels that can be zapped to. These channels reappear in the pool of channels that can be zapped to as new programmes appear on them.

Each of the methods described above state that discarded channels reappear in the pool of channels that can be zapped to as new programmes appear on them. In a first further enhancement of the system, which will be referred to as further enhancement 1, these channels are given priority. Thus, if a new programme or item appeared on a channel that was previously discarded, that channel will be selected the next time the viewer changes channel. Priority will be given to the newest programmes and items. Thus, if a new programme or item appears on channel A and then, some time later, on channel B (where both channels A & B had been previously discarded) priority will be given to channel B and then channel A. As mentioned before, the enhanced zapping functionality described herein can be achieved with a single `zap' button, which would nominally have the effect of a 'channel up' button. When the first enhancement is implemented, i.e. the system gives priority to new programmes and items, hitting the zap button would signify that the user wishes to see new content rather than the next channel in the channel list.

As a further enhancement, which will be referred to as further enhancement 2, the system may be adapted to allow the user to define the criteria under which channels are discarded from and returned to the list of channels that can be "zapped' to. For example, a time 'X' (in seconds) can be set by the user. A channel is only discarded if it is viewed for *at least* 'X' seconds. Otherwise, it is assumed that the channel was not properly assessed, for example because an advertisement was showing at the time. Also, an optional time limit `Y' (in minutes) can be set by the user. Once discarded, a channel is always returned to the pool of channels that can be 'zapped' to after 'Y' minutes, the pool of available channels being stored in the memory 36 of Figure 1.

Additionally, the system may be adapted to allow a user to discard particular types of programme. This will be referred to as further enhancement 3. For example, the system may be operable to discard all sports channels or channels that are currently broadcasting sports programmes. In this case, when a channel of a particular genre is discarded, all other channels showing the same genre of programme can be discarded as well. Alternatively, rather than discard these channels altogether, the system may be operable to give them a lower priority than channels showing programmes of other genres. In either case, when the single zap button is used, pressing that 'zap' button allows the viewer to channel hop to programmes of other genres.

As a yet further enhancement, which will be referred to as further enhancement 4, if a channel is currently showing an advertisement, the enhanced zap mechanism 34 may be operable to temporarily remove this channel from the pool of channels that can be zapped to. As soon as the advertisements have finished, the channel is restored, making it available for zapping (and, hence, more permanent removal from the pool of channels if discarded by the viewer). Another possibility is to show a stored clip of video when zapping to a channel that is currently showing an advertisement. In the case of an advertisement break within a programme, the last minute or so of the programme (before the break started) could be shown. In the case of a break between programmes, the receiver could present a display of the digital description of the following programme (the programme meta-data). Or, if it should be available to the receiver, a video clip from, or trailer for, the following programme could be shown.

A more specific description of the methodology for implementing the invention will now be given with reference to Figures 3 to 5.

Figure 3 shows various steps for implementing enhanced zapping. These steps are all carried out in the enhanced zapping mechanism of Figure 1. When the channel-zapping mode is entered, the first step 58 is to determine the initial channel to which the tuner 12 has to be tuned and various set up parameters. The first of these set-up parameters is a value for the optional timeout T1. The system is designed so that for any discarded channel, after this optional timeout has expired, the channel is re-introduced into the pool of available channels. The timeout T1 can be set by either reverting to a default value stored in the memory 36 or by prompting the user to enter a value.

Once the optional timeout T1 is determined, it is established if new programmes are to be given priority,· i.e. whether further enhancement 1 is to be implemented. Then, the type of timing that is to be used to determine whether or not channels are to be discarded is established, i.e. further enhancement 2, by either reverting to a stored value or by prompting the user to make the appropriate selection. If the "at least" option is chosen, then channels are discarded if they are viewed for at least the time set by the user. If the "at most" option is selected, then channels are not discarded if they are viewed for at most the set time. Once the type of timing is selected, then the duration of the viewing time T2 is set. Again a default or pre-set value could be used or the user could manually enter a value. Blocking of particular types of programme can also be set up at this stage, i.e. further enhancement 3, as can the option to exclude, channels that are showing adverts from the available channel pool, i.e. further enhancement 4. This set up routine can be done each time the user selects the enhanced zapping mode or alternatively, can be implemented using stored criteria.

Once the set-up parameters for the zapping session are identified, the tuner is tuned to the chosen channel 60. To do this, the channel zapping mechanism sends a command to the channel change mechanism to cause the tuner to change to the first channel chosen by the user. The timer is then set to determine the amount of time the user views that channel 62. Then the zapping mechanism waits for an event to occur 64. The events could be one of the following: expiry of the optional timeout T1; expiry of T2; a user input, such as a channel change command; end of programme or item on an excluded channel; start of an advert on one channel in the channel pool; end of advert on one channel of the channel pool. Once an event is detected, it is processed 66.

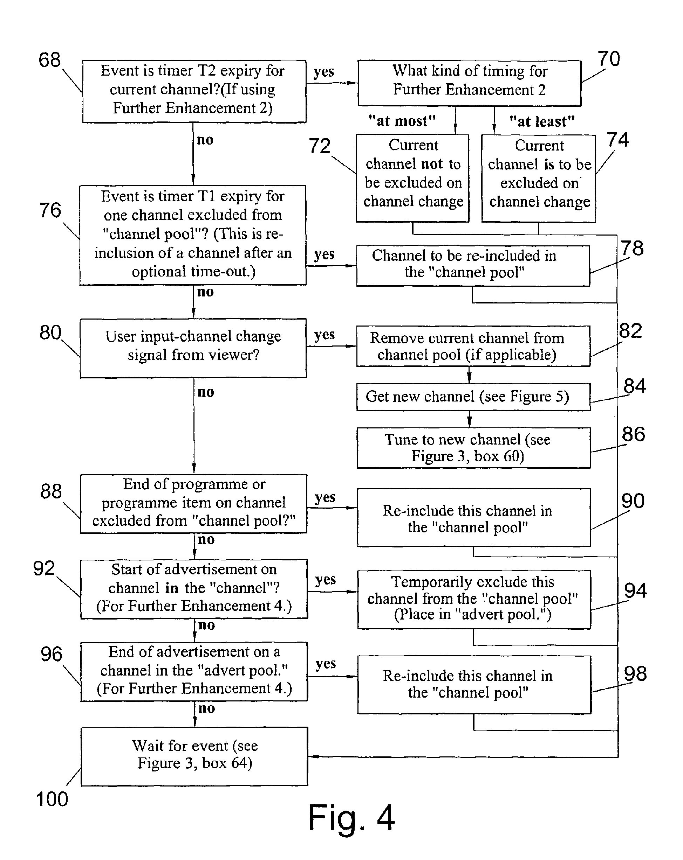

Figure 4 shows the steps involved in the processing of an event, this processing being event dependent. The first step of this is to determine whether the event is expiry of T2. If it is then the next step 70 is for the zapping mechanism to determine the type of timing selected at set up. If the timing is "at most" then in the next step 72 it is determined that the current channel is not to be excluded when the next channel change is made. In contrast, if the timing is "at least", then the next step 74 is to exclude the current channel from the pool of available channels. Hence, the pool of available channels stored in memory 36 of Figure 1 is up-dated to reflect that the current channel is excluded. If the event is not expiry of T2, then it is determined in step 76 whether the event is timer T1 expiry for one channel. If the answer to this is yes, then at step 78 that channel is re-introduced to the pool of available channels. Again, the pool of available channels stored in memory 36 of Figure 1 is up-dated to reflect this.

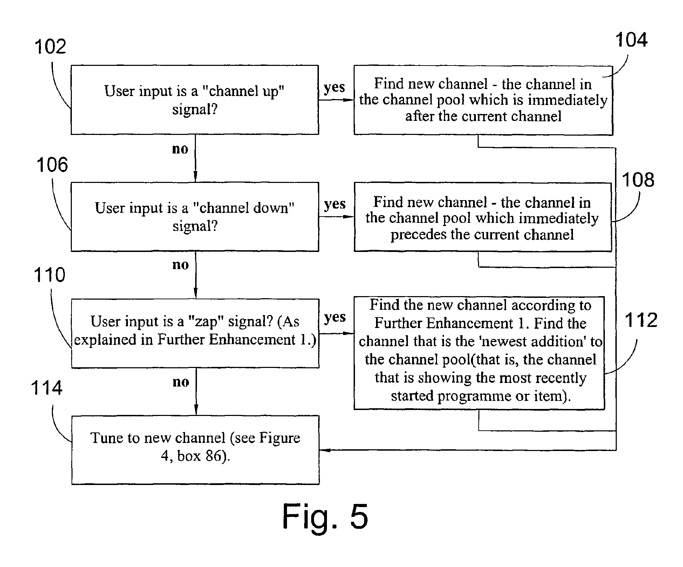

If the event is identified at step 80 as being a channel change command, then the current channel is removed 82 from the available pool (if applicable) and the new channel is obtained 84. Figure 5 shows the steps for doing this in more detail. The zapping mechanism 34 firstly determines at step 102 whether the user input is a channel up or a channel down command. In the case where it is a channel up command, the new channel is identified in step 104 as being the channel in the pool of available channels that is immediately after the current channel. In the case where it is a channel down command 106, the new channel is identified in step 108 as being the channel in the pool of available channels that immediately precedes the current channel. If the user input is identified at step 110 as being a "zap" signal, the zapping mechanism finds 112 the channel that is the newest addition to the channel pool, that is the channel that is showing the most recently started programme or item. In any case, once the channel change command is received and interpreted by the zapping mechanism 34, the final step 114 is to send the appropriate control signal to the channel change mechanism 26, which in turn sends a channel change command to the tuner 12.

Returning to Figure 4, if the zapping mechanism identifies at step 88 that the event is the end of a programme or item on a channel excluded from the channel pool, then this channel is re-included 90 in the pool. If the zapping mechanism identifies 92 the start of an advertisement on a channel in the channel pool, then this channel is temporarily excluded 94 from the pool. If the event that is identified is the end of an advertisement 96, the zapping mechanism re-introduces, at step 98, the channel to the channel pool.

In any case, after an event is processed, the next step 100 is to wait for further events. The above-described process of monitoring events such as user inputs and changes of television programme and reacting to these events to change the pool of available channels continues until the user exits the zapping mode and returns to a normal viewing mode.

Whilst the system 10 of Figure 1 is described as being included in a single self-contained enclosure such as a digital television, it will be appreciated that the channel-zapping functionality may be built into a set top box. In this case, all elements of the receiver circuitry would be within the same enclosure, but the display would be provided within a separate unit, for example a television set.

The channel zapping mechanism of the present application uses the digital TV receiver to perform part of the channel hopping task. When channel hopping up and down, people are aware of what they have 'hopped to' in the past and go into 'fast thumb' mode. This invention exploits the digital data available in the broadcast to make the process easier.

The channel zapping method described herein allows the user to benefit from not having to 'channel hop' through channels showing programmes (or programme items) that he is not interested in. This is particularly advantageous for digital television systems where the number of channels and channel change times are very much greater than for analogue systems.

A skilled person will appreciate that variations of the disclosed arrangements are possible without departing forum the invention. For example, whilst the description generally refers to programmes being broadcast, it will be appreciated that other ways for transmitting these could equally be used. Also, whilst the invention has been described with reference to television, it will be appreciated that it could equally be applied to digital radio. Accordingly, the above description of a specific embodiment is made by way of example only and not for the purposes of limitation. It will be clear to the skilled person that minor modifications may be made without significant changes to the operation described.

## Claims

1. A method for controlling channel changes in television or digital radio having a tuner or receiver, the method involving monitoring channel change commands received from a user over a zapping session during which channels are discarded; identifying discarded channels; and preventing the tuner or receiver from returning to the discarded channels during the rest of the zapping session unless it is determined that a programme transmitted on the discarded channel has changed, wherein the step of identifying discarded channels involves monitoring a time for which the viewer viewed the channel and on the basis of this, determining whether the channel is discarded.

2. A method as claimed in claim 1, comprising setting a viewing time threshold for use in the step of determining whether the channel is to be discarded.

3. A method as claimed in claim 2, wherein if the monitored viewing time is at most the viewing time threshold, then the channel is retained.

4. A method as claimed in claim 2, wherein if the monitored viewing time is at least the viewing time threshold, then the channel is discarded.

5. A method as claimed in any of claims 2 to claim 4 comprising receiving a user input indicative of the time set.

6. A method as claimed in any of the preceding claims comprising determining whether a programme on a particular channel has changed.

7. A method as claimed in claim 6 wherein the step of determining whether a programme has changed involves comparing programme identifiers for the previously viewed programme and the currently viewed programme.

8. A method as claimed in claim 6 wherein the step of determining whether a programme on a particular channel has changed involves monitoring real time; identifying programme scheduling information for a particular channel and using the scheduling information and real time to determine whether there is a change in the currently broadcast programme.

9. A method as claimed in any of the preceding claims involving receiving a control signal from the user that indicates that a channel zapping session is starting, this signal prompting the start of the step of monitoring the channels zapped to and those discarded.

10. A method as claimed in any of the preceding claims, wherein the method involves receiving from a user a signal that is indicative of a command to stop the channel zapping session.

11. A method as claimed in any of the preceding claims comprising terminating the channel zapping session if no channel change commands are received over a pre-determined time.

12. A method as claimed in any of the preceding claims comprising identifying an advertisement, temporarily excluding the channel that the advertisement is being shown on from the pool of available channels and reintroducing the channel when the advertisement is finished.

13. A method as claimed in any of the preceding claims comprising identifying an advertisement and showing material, such as a video clip or text, which is associated with the programme that is to be shown when the advertisement is finished.

14. A method as claimed in claim 13 further involving recording a portion of the programme shown immediately preceding the advertisement and displaying this to the user during the advertisement.

15. A method as claimed in claim 14 comprising carrying out the step of recording for all available channels.

16. A method as claimed in any of the preceding claims comprising monitoring programme changes; identifying the most recently provided or broadcast programme and presenting the most recently provided or broadcast programme to the user in response to a channel change command.

17. A system for controlling channel changes in television or digital radio having a tuner or receiver, the system comprising means for monitoring channel change commands received from a user over a zapping session during which channels are discarded; means for identifying discarded channels; and means for preventing the tuner or receiver from tuning to the discarded channels during the rest of the zapping session unless it is determined that a programme transmitted on the discarded channel has changed, wherein the means for identifying discarded channels comprise means for monitoring a time for which the viewer viewed the channel and on the basis of this, determining whether the channel is discarded.

18. A system as claimed in claim 17, comprising means for setting a viewing time threshold for use by the means for determining whether the channel is to be discarded.

19. A system as claimed in claim 18, wherein if the monitored viewing time is at most the viewing time threshold, then the channel is retained.

20. A system as claimed in claim 18, wherein if the monitored viewing time is at least the set viewing time threshold, then the channel is discarded.

21. A system as claimed in any of claims 17 to claim 20 comprising means for receiving a user input indicative of the times set.

22. A system as claimed in any of claims 17 to 21 comprising means for determining whether a programme on a particular channel has changed.

23. A system as claimed in claim 22, wherein the means for determining whether a programme has changed comprise means for comparing programme identifiers for the previously viewed channel and the programme currently available.

24. A system as claimed in any of claims 17 to 23, wherein the means for determining whether a programme on a particular channel has changed are operable to monitor real time; identify programme scheduling information for a particular channel and use the scheduling information and real time to determine whether there is a change in the currently broadcast programme.

25. A system as claimed in any of claims 17 to 24 comprising means for receiving a control signal from the user indicative of the start of a channel zapping session, means for recognising the signal as a zapping session identifier and activating the means for monitoring the channels zapped to and those discarded in response to the zapping command.

26. A system as claimed in any of claims 17 to 25, comprising means for receiving from a user a signal that is indicative of a command to stop the channel zapping session.

27. A system as claimed in any of claims 17 to 26 comprising means for terminating the channel zapping session if no channel change commands are received over a pre-determined time.

28. A system as claimed in any of claims 17 to 27 comprising a display for showing the programmes on.

29. A system as claimed in any of claims 17 to 28 being adapted to receive channel change commands from a remote control.

30. A computer program, preferably on a data carrier or some other computer readable medium, for controlling channel changes in a television or digital radio having a tuner or receiver, the computer program having code or instructions for monitoring channel change commands received from a user over a zapping session during which channels are discarded; identifying discarded channels; and preventing the tuner or receiver from tuning to the discarded channels during the rest of the zapping session unless it is determined that a programme transmitted on the discarded channel has changed, wherein the code or instructions for determining discarded channels are operable to monitor a time for which the viewer viewed the channel and on the basis of this, determine whether the channel is discarded.

31. A computer program as claimed in claim 30, comprising code or instructions for setting a viewing time threshold for use by the means for determining whether the channel is to be discarded.

32. A computer program as claimed in claim 31, wherein if the monitored viewing time is at most the viewing time threshold, then the channel is retained.

33. A computer program as claimed in claim 31, wherein if the monitored viewing time is at least the set viewing time threshold, then the channel is discarded.

34. A computer program as claimed in any one of claims 30 to 33 comprising code or instructions for receiving a user input indicative of the times.

35. A computer program as claimed in any of claims 30 to 34 comprising code or instructions for determining whether a programme on a particular channel has changed.

36. A computer program as claimed in claim 35, wherein the code or instructions for determining whether a program has changed are operable to compare program identifiers for the previously viewed program and the program currently available.

37. A computer program as claimed in any of claims 30 to
36. wherein the code or instructions for identifying whether a programme on a particular channel has changed are operable to monitor real time; identify programme scheduling information for a particular channel and using the scheduling information and real time to determine whether there is a change in the currently broadcast programme.

38. A computer program as claimed in any of claims 30 to 37 comprising code or instructions for receiving a control signal from the user that indicates that a channel zapping session is starting, this signal prompting the start of the step of monitoring the channels zapped to and those discarded.

39. A computer program as claimed in any of claims 30 to 35, wherein the code or instructions are operable to receive from a user a signal that is indicative of a command to stop the channel zapping session.

40. A computer program as claimed in any of claims 30 to 39 comprising code or instructions for terminating the channel zapping session if no channel change commands are received over a pre-determined time.

41. A set top box that includes a system or computer program as defined in the preceding claims.

42. A television system that includes a system or computer program as defined in the preceding claims.

43. A digital radio that includes a system or computer program as defined in the preceding claims.

## Patentansprüche

1. Verfahren zum Steuern von Kanalwechseln im Fernsehen oder Digitalrundfunk mit einem Tuner oder Empfänger, das Verfahren die Überwachung von Kanahvechsetbefehten cinschließend, die von einem Benutzer über eine Zapping-Sitzung empfangen werden, in deren Verlauf Kanäle verworfen werden; Identifizieren von verworfenen Kanälen; und Verhindern, dass der Tuner oder Empfänger während des Rests der Zapping-Sitznng zu den verworfenen Kanälen zurückkehrt, ausgenommen es wird bestimmt, dass ein auf dem verworfenen Kanal übertragenes Programm gewechselt wurde, worin der Schritt des Identifizierens von verworfenen Kanälen das Überwachen einer Zeit einschließt, während der sich der Zuschauer den Kanal angesehen hat, und darauf basierend die Bestimmung, ob der Kanal verworfen wird.

2. Verfahren nach Anspruch 1, das Einstellen einer Fernsehzeitschwelle zur Verwendung im Schritt des Bestimmens umfassend, ob der Kanal zu verwerfen ist.

3. Verfahren nach Anspruch 2, worin der Kanal beibehalten wird, falls die überwachte Fernsehzeit höchstens die Fernsehzeitschwelle ist.

4. Verfahren nach Anspruch 2, worin der Kanal verworfen wird, falls die überwachte Femsehzeit mindestens die Fernsehzeitschwelle ist.

5. Verfahren nach einem der Ansprüche 2 bis 4, das Empfangen einer Benutzereingabe umfassend, die die eingestellte Zeit anzeigt.

6. Verfahren nach einem der vorhergehenden Ansprüche, das Bestimmen umfassend, ob ein Programm auf einem bestimmten Kanal gewechselt wurde.

7. Verfahren nach Anspruch 6, worin der Schritt des Bestimmens, ob ein Programm gewechselt wurde, das Vergleichen von Programmkennungen für das vorher angesehene Programm und das gegenwärtig angesehene Programm einschließt.

8. Verfahren nach Anspruch 6, worin der Schritt des Bestimmens, ob ein Programm auf einem bestimmten Kanal gewechselt wurde, Echtzeitübenvachung umfasst; Identifizieren von Programm-Zeitplanungsinformation für einen bestimmten Kanal und Verwenden der Zeitplanungsinformation und Echtzeit, um zu bestimmen, ob es im gegenwärtig ausgestrahlten Programm einen Wechsel gibt.

9. Verfahren nach einem der vorhergehenden Ansprüche, den Empfang eines Steuersignals vom Benutzer einschließend, das den Beginn einer Zapping-Sitzung anzeigt, wobei das Signal den Beginn des Schritts der Überwachung der Kanäle veranlasst, auf die gezappt wurde, und der Kanäle, die verworfen wurden.

10. Verfahren nach einem der vorhergehenden Ansprüche, worin das Verfahren den Empfang eines Signals von einem Benutzer umschließt, das einen Befehl anzeigt, die Kanal-Zapping-Sitzung zu beenden.

11. Verfahren nach einem der vorhergehenden Ansprüche, das Beenden der Kanal-Zapping-Sitzung umfassend, falls keine Kanalwechselbefehle während einer vorbestimmten Zeit empfangen werden.

12. Verfahren nach einem der vorhergehenden Ansprüche, Folgendes umfassend: eine Werbung identifizieren, den Kanal, auf dem die Werbung gezeigt wird, aus dem Pool verfügbarer Kanäle vorübergehend ausschließen und den Kanal wieder einführen, wenn die Werbung beendet ist.

13. Verfahren nach einem der vorhergehenden Ansprüche, das Identifizieren einer Werbung umfassend und Material zeigend wie beispielsweise einen Videoclip oder Text, der mit dem Programm assoziiert ist, das gezeigt werden soll, wenn die Werbung beendet ist.

14. Verfahren nach Anspruch 13, außerdem das Aufnehmen eines Teils des Programms einschließend, der unmittelbar vor der Werbung gezeigt wird, und diesen dem Benutzer während der Werbung anzeigen.

15. Verfahren nach Anspruch 14, das Ausführen des Aufnahmeschritts für alle verfügbaren Kanäle umfassend.

16. Verfahren nach einem der vorhergehenden Ansprüche, Folgendes umfassend: Programmwechssl Überwachen; das zuletzt bereitgestellte oder ausgestrahlte Programm identifizieren und dem Benutzer als Reaktion auf einen Kanalwechselbefehl das zuletzt bereitgestellte oder ausgestrahlte Programm darbieten.

17. System zum Steuern von Kanalwechseln im Fernsehen oder Digitalrundfunk mit einem Tuner oder Empfänger, das System ein Mittel zum Überwachen von Kanalwechselbefehlen umfassend, die von einem Benutzer über eine Zapping-Sitzung empfangen werden, in deren Verlauf Kanäle verworfen werden; ein Mittel zum Identifizieren von verworfenen Kanälen; und ein Mittel zum Verhindern, dass der Tuner oder Empfänger während des Rests der Zapping-Sitzung die venvorfenen Kanäle einstellt, ausgenommen es wird bestimmt, dass ein auf dem verworfenen Kanal übertragenes Programm gewechselt wurde, worin das Mittel zum Identifizieren von verworfenen Kanälen ein Mittel zum Überwachen einer Zeit umfasst, während der sich der Zuschauer den Kanal angesehen hat und darauf basierend bestimmt, ob der Kanal verworfen wird.

18. System nach Anspruch 17, ein Mittel zum Einstellen einer Fernsehzeitschwelle zur Verwendung durch das Mittel zum Bestimmen umfassend, ob der Kanal zu verwerfen ist.

19. System nach Anspruch 18, worin der Kanal beibehalten wird, falls die überwachte Fernsehzeit höchstens die Fernsehzeitschwelle ist.

20. System nach Anspruch 18, worin der Kanal verworfen wird, falls die überwachte Fernsehzeit mindestens die Fernsehzeitschwelle ist.

21. System nach einem der Ansprüche 17 bis 20, ein Mittel zum Empfangen einer Benutzereingabe umfassend, die die eingestellten Zeiten anzeigt.

22. System nach einem der Ansprüche 17 bis 21, ein Mittel zum Bestimmen umfassend, ob ein Programm auf einem bestimmten Kanal gewechselt wurde.

23. System nach Anspruch 22, worin das Mittel zum Bestimmen, ob ein Programm gewechselt wurde, ein Mittel zum Vergleichen von Programmkennungen Für den vorher angesehenen Kanal und das gegenwärtig verfügbare Programm umfasst.

24. System nach einem der Ansprüche 17 bis 23, worin das Mittel zum Bestimmen, ob ein Programm auf einem bestimmten Kanal gewechselt wurde, zur Echtzeitüberwachung betriebsbereit ist; zum Identifizieren von Programm-Zeitplanungsinformation für einen bestimmten Kanal und zum Verwenden der Zeitplanungsinformation und Echtzeit, um zu bestimmen, ob es im gegenwärtig ausgestrahlten Programm einen Wechsel gibt.

25. System nach einem der Anspräche 17 bis 24, ein Mittel zum Empfang eines Steuersignals vom Benutzer umfassend, das den Beginn einer Kanal-Zapping-Sitzung anzeigt, ein Mittel zum Erkennen des Signals als eine Zapping-Sitzungskennung und zum Aktivieren des Mittels zum Überwachen der Kanäle, auf die gezappt wurde, und der Kanäle, die verworfen wurden als Reaktion auf den Zapping-Befehl.

26. System nach einem der Ansprüche 17 bis 25, ein Mittel zum Empfang eines Signals von einem Benutzer umfassend, das einen Befehl anzeigt, die Kanal-Zapping-Sitzung zu beenden.

27. System nach einem der Ansprüche 17 bis 26, ein Mittel zum Beenden der Kanal-Zapping-Sitzung umfassend, falls keine Kanalwechselbefehle während einer vorbestimmten Zeit empfangen werden.

28. System nach seinem der Ansprüche 17 bis 27, ein Display zum Zeigen der Programme umfassend.

29. System nach einem der Ansprüche 17 bis 28, dazu angepasst, Kanalwechsalbefehle von einer Fernbedienung zu empfangen.

30. Computerprogramm, vorzugsweise auf einem Datenträger oder einem anderen computerlesbaren Medium zum Steuern von Kanalwechseln im Fernsehen oder Digitalrundfunk mit einem Tuner oder Empfänger, wobei das Programm Code oder Anweisungen hat zum Überwachen von Kanalwechselhefehlen, die von einem Benutzer über eine Zapping-Sitzung empfangen werden, in deren Verlauf Kanäle verworfen werden; Identifizieren von verworfenen Kanälen; und Verhindern, dass der Tuner oder Empfänger während des Rests der Zapping-Sitzung die verworfenen Kanäle einstellt, ausgenommen es wird bestimmt, dass ein auf dem verworfenen Kanal übertragenes Programm gewechselt wurde, worin der Code oder Anweisungen zum Identifizieren von verworfenen Kanälen betriebsbereit sind, eine Zeit zu überwachen, während der sich der Zuschauer den Kanal angesehen hat, und darauf basierend zu bestimmen, ob der Kanal verworfen wird.

31. Computerprogramm nach Anspruch 30, Code oder Anweisungen zum Einstellen einer Fernschzeitschwelle zur Verwendung durch das Mittel zum Bestimmen umfassend, ob der Kanal zu verwerfen ist.

32. Computerprogramm nach Anspruch 31, worin der Kanal beibehalten wird, falls die überwachte Fernsehzeit höchstens die Fernsehzeitschwelle ist.

33. Computerprogramm nach Anspruch 31, worin der Kanal verworfen wird, Calls die überwachte Fernsehzeit mindestens die Fernsehzeitschwelle ist.

34. Computerprogramm nach einem der Ansprüche 30 bis 33, Code oder Anweisungen zum Empfangen einer Benutzereingabe umfassend, die die Zeiten anzeigt.

35. Computerprogramm nach einem der Ansprüche 30 bis 34, Code oder Anweisungen zum Bestimmen umfassend, ob ein Programm auf einem bestimmten Kanal gewechselt wurde.

36. Computerprogramm nach Anspruch 35, worin der Code oder Anweisungen zum Bestimmen, ob ein Programm gewechselt wurde, betriebsbereit sind zum Vergleichen von Programmkennungen für das vorher angesehene Programm und das gegenwärtig verfügbare Programm.

37. Computerprogramm nach einem der Ansprüche 30 bis 36, worin der Code oder Anweisungen zum Identifizieren, ob ein Programm auf einem bestimmten Kanal gewechselt wurde, zur Echtzeitübervachung betriebsbereit sind; zum Identifizieren von Programm-Zeitplanungsinformation für einen bestimmten Kanal und zum Verwenden der Zeitplanungsinformation und Echtzeit zum Bestimmen, ob es im gegenwärtig ausgestrahlten Programm einen Wechsel gibt.

38. Computerprogramm nach einem der Ansprüche 30 bis 37, Code oder Anweisungen zum Empfang eines Steuersignals vom Benutzer umfassend, das den Beginn einer Kanal-Zapping-Sitzung anzeigt, wobei dieses Signal den Beginn des Schritts des Überwachens der Kanäle veranlasst, zu denen gezappt wurde, und der Kanäle, die verworfen wurden,

39. Computerprogramm nach einem der Ansprüche 30 bis 38, worin der Code oder die Anweisungen betriebsbereit sind, von einem Benutzer ein Signal zu empfangen, das einen Befehl anzeigt, die Kanal-Zapping-Sitzung zu beenden.

40. Computerprogramm nach einem der Ansprüche 30 bis 39, Code oder Anweisungen zum Beenden der Zapping-Sitzung umfassend, falls während einer vorbestimmten Zeit keine Kanalwechselbefehle empfangen werden.

41. Set-Top-Box, die ein System oder Computerprogramm enthält, wie in den vorhergehenden Ansprüchen definiert ist.

42. Fernsehsystem, das ein System oder Computerprogramm enthält, wie in den vorhergehenden Ansprüchen definiert ist.

43. Digitalrundfunk, das ein System oder Computerprogramm enthält, wie in den vorhergehenden Ansprüchen definiert ist.

## Revendications

1. Procédé destiné à contrôler des changements de canal sur une télévision ou une radio numérique présentant un syntoniseur ou un récepteur, le procédé impliquant les étapes consistant à surveiller des commandes de changement de canal reçues d'un utilisateur au long d'une session de zapping au cours de laquelle des canaux sont rejetés ; à identifier les canaux rejetés ; et à empêcher le syntoniseur ou récepteur de revenir aux canaux rejetés au cours du reste de la session de zapping à moins qu'il ne soit déterminé qu'un programme émis sur le canal rejeté a changé, dans lequel l'étape consistant à identifier les canaux rejetés implique l'étape consistant à surveiller un temps pendant lequel le téléspectateur a visualisé le canal et, sur la base de cela, à déterminer si le canal est rejeté.

2. Procédé selon la revendication 1, comportant l'étape consistant à régler un seuil de temps de visualisation qui doit être utilisé dans l'étape consistant à déterminer si le canal doit être rejeté.

3. Procédé selon la revendication 2, dans lequel si le temps de visualisation surveillé est au maximum le seuil de temps de visualisation, alors le canal est conservé.

4. Procédé selon la revendication 2, dans lequel si le temps de visualisation surveillé est au moins le seuil de temps de visualisation, alors le canal est rejeté.

5. Procédé selon l'une quelconque des revendications 2 à 4 comportant l'étape consistant à recevoir une entrée d'utilisateur indiquant le temps réglé.

6. Procédé selon l'une quelconque des revendications précédentes, comportant l'étape consistant à déterminer si un programme sur un canal particulier a changé.

7. Procédé selon la revendication 6, dans lequel l'étape consistant à déterminer si un programme a changé implique l'étape consistant à comparer des identifiants de programme du programme visualisé précédemment et du programme visualisé en cours.

8. Procédé selon la revendication 6, dans lequel l'étape consistant à déterminer si un programme sur un canal particulier a changé implique les étapes consistant à surveiller le temps réel ; à identifier des informations de planification de programme d'un canal particulier et à utiliser les informations de planification et le temps réel pour déterminer s'il existe un changement dans le programme de diffusion en cours.

9. Procédé selon l'une quelconque des revendications précédentes, comportant l'étape consistant à recevoir un signal de commande en provenance de l'utilisateur qui indique qu'une session de zapping de canaux démarre, ce signal invitant au démarrage de l'étape consistant à surveiller les canaux choisis au cours du zapping et ceux rejetés.

10. Procédé selon l'une quelconque des revendications précédentes, dans lequel le procédé implique l'étape consistant à recevoir, d'un utilisateur, un signal qui indique une commande d'arrêt de la session de zapping de canaux.

11. Procédé selon l'une quelconque des revendications précédentes, comportant l'étape consistant à mettre fin à la session de zapping de canaux lorsqu'aucune commande de changement de canal n'est reçue sur une période de temps prédéterminée.

12. Procédé selon l'une quelconque des revendications précédentes, comportant les étapes consistant à identifier une annonce publicitaire, à exclure temporairement le canal sur lequel l'annonce publicitaire est diffusée du groupe de canaux disponibles et à réintroduire le canal lorsque l'annonce publicitaire est terminée.

13. Procédé selon l'une quelconque des revendications précédentes, comportant l'étape consistant à identifier une annonce publicitaire et un support de contenu, comme un clip vidéo ou du texte, qui est associé au programmes qui doit être montré lorsque l'annonce publicitaire est terminée.

14. Procédé selon la revendication 13, impliquant en outre les étapes consistant à enregistrer une partie du programme montrée immédiatement avant l'annonce publicitaire et à afficher celui-ci à l'utilisateur au cours de l'annonce publicitaire.

15. Procédé selon la revendication 14, comportant l'étape consistant à mettre en oeuvre l'étape d'enregistrement pour tous les canaux disponibles.

16. Procédé selon l'une quelconque des revendications précédentes, comportant les étapes consistant à surveiller des changements de programme ; à identifier le plus récent programme diffusé ou proposé et à présenter le plus récent programme diffusé ou proposé à l'utilisateur en réponse à une commande de changement de canal.

17. Système destiné à contrôler des changements de canal sur une télévision ou une radio numérique présentant un syntoniseur ou un récepteur, le système comportant un moyen permettant de surveiller des commandes de changement de canal reçues d'un utilisateur au long d'une session de zapping au cours de laquelle des canaux sont rejetés ; un moyen pour identifier des canaux rejetés ; et un moyen pour empêcher le syntoniseur ou récepteur de syntoniser vers les canaux rejetés au cours du reste de la session de zapping à moins qu'il ne soit déterminé qu'un programme émis sur le canal rejeté a changé, dans lequel le moyen pour identifier les canaux rejetés comporte un moyen pour surveiller un temps pendant lequel le téléspectateur a visualisé le canal et sur la base de cela, pour déterminer si le canal est rejeté.

18. Système selon la revendication 17, comportant un moyen permettant de régler un seuil de temps de visualisation destiné à être utilisé par le moyen permettant de déterminer si le canal doit être rejeté.

19. Système selon la revendication 18, dans lequel si le temps de visualisation surveillé est au maximum le seuil de temps de visualisation, alors le canal est conservé.

20. Système selon la revendication 18, dans lequel si le temps de visualisation surveillé est au moins le seuil de temps de visualisation réglé, alors le canal est rejeté.

21. Système selon l'une quelconque des revendications 17 à 20, comportant un moyen permettant de recevoir une entrée d'utilisateur indiquant le temps réglé.

22. Système selon l'une quelconque des revendications 17 à 21, comportant un moyen permettant de déterminer si un programme sur un canal particulier a changé.

23. Système selon la revendication 22, dans lequel le moyen pour déterminer si un programme a changé comporte un moyen permettant de comparer des identifiants de programme du canal visualisé précédemment et du programme disponible à ce moment.

24. Système selon l'une quelconque des revendications 17 à 23, dans lequel le moyen permettant de déterminer si un programme sur un canal particulier a changé est exploitable pour surveiller le temps réel, pour identifier des informations de planification de programme d'un canal particulier et pour utiliser les informations de planification et le temps réel afin de déterminer s'il existe un changement dans le programme de diffusion en cours.

25. Système selon l'une quelconque des revendications 17 à 24, comportant un moyen permettant de recevoir un signal de commande en provenance de l'utilisateur lequel signal indique le début d'une session de zapping de canaux, un moyen permettant de reconnaître le signal en tant qu'identifiant de session de zapping et d'activer le moyen permettant de surveiller les canaux choisis au cours du zapping et ceux rejetés, en réponse à la commande de zapping.

26. Système selon l'une quelconque des revendications 17 à 25, comportant un moyen permettant de recevoir, d'un utilisateur, un signal qui indique une commande d'arrêt de la session de zapping de canaux.

27. Système selon l'une quelconque des revendications 17 à 26, comportant un moyen permettant de mettre fin à la session de zapping de canaux lorsqu'aucune commande de changement de canal n'est reçue sur une période de temps prédéterminée.

28. Système selon l'une quelconque des revendications 17 à 27, comportant un écran d'affichage sur lequel montrer les programmes.

29. Système selon l'une quelconque des revendications 17 à 28, lequel système est apte à recevoir des commandes de changement de canal en provenance d'une télécommande.

30. Programme informatique, de préférence installé sur une porteuse de données ou sur un autre support lisible par ordinateur, destiné à contrôler des changements de canal sur une télévision ou une radio numérique présentant un syntoniseur ou un récepteur, le programme informatique présentant un code ou des instructions destinés à surveiller des commandes de changement de canal reçues d'un utilisateur au long d'une session de zapping au cours de laquelle des canaux sont rejetés ; à identifier les canaux rejetés ; et à empêcher le syntoniseur ou le récepteur de syntoniser vers les canaux rejetés au cours du reste de la session de zapping à moins qu'il ne soit déterminé qu'un programme émis sur le canal rejeté a changé, dans lequel le code ou les instructions permettant de déterminer les canaux rejetés sont exploitables pour surveiller un temps pendant lequel le téléspectateur a visualisé le canal et sur la base de cela, déterminer si le canal est rejeté.

31. Programme informatique selon la revendication 30, comportant un code ou des instructions permettant de régler un seuil de temps de visualisation destiné à être utilisé par le moyen permettant de déterminer si le canal doit être rejeté.

32. Programme informatique selon la revendication 31, dans lequel si le temps de visualisation surveillé est au maximum le seuil de temps de visualisation, alors le canal est conservé.

33. Programme informatique selon la revendication 31, dans lequel si le temps de visualisation surveillé est un moins le seuil de temps de visualisation réglé, alors le canal est rejeté.

34. Programme informatique selon l'une quelconque des revendications 30 à 33, comportant un code ou des instructions permettant de recevoir une entrée d'utilisateur indiquant les temps.

35. Programme informatique selon l'une quelconque des revendications 30 à 34, comportant un code ou des instructions permettant de déterminer si un programne sur un canal particulier a changé.

36. Programme informatique selon la revendication 35, dans lequel le code ou les instructions permettant de déterminer si un programme a changé sont exploitables pour comparer des identifiants de programme du programme visualisé précédemment et du programme visualisé en cours.

37. Programme informatique selon l'une quelconque des revendications 30 à 36, dans lequel le code ou les instructions destinés à identifier si un programme sur un canal particulier a changé sont exploitables pour surveiller le temps réel ; pour identifiers des informations de planification de programme d'un canal particulier et pour utiliser les informations de planification et le temps réel afin de déterminer s'il existe un changement dans le programme de diffusion en cours.

38. Programme informatique selon l'une quelconque des revendications 30 à 37, comportant un code ou des instructions permettant de recevoir un signal de commande en provenance de l'utilisateur lequel signal indique qu'une session de zapping de canaux démarre, ce signal invitant au démarrage de l'étape consistant à surveiller les canaux choisis au cours du zapping et ceux rejetés.

39. Programme informatique selon l'une quelconque des revendications 30 à 38, dans lequel le code ou les instructions sont exploitables pour recevoir, d'un utilisateur, un signal qui indique une commande d'arrêt de la session de zapping de canaux.

40. Programme informatique selon l'une quelconque des revendications 30 à 39, comportant un code ou des instructions permettant de mettre fin à la session de zapping de canaux lorsqu'aucune commande de changement de canal n'est reçue sur une période de temps prédéterminée.

41. Boîtier décodeur qui comporte un programme informatique ou un système selon l'une quelconque des revendications précédentes.

42. Système de télévision qui comporte un programme informatique ou un système selon l'une quelconque des revendications précédentes,

43. Radio numérique qui comporte un programme informatique ou un système selon l'une quelconque des revendications précédentes.
